(19) Europäisches Patentamt
European Patent Office
Office européen des brevets

(11) **EP 1 640 733 B1**

(12) **EUROPEAN PATENT SPECIFICATION**

(45) Date of publication and mention
of the grant of the patent:
**27.04.2011 Bulletin 2011/17**

(51) Int Cl.:
*G01R 25/08* (2006.01)  *G01R 25/00* (2006.01)
*H04L 7/033* (2006.01)  *H04L 1/20* (2006.01)
*H03L 7/091* (2006.01)

(21) Application number: **04292278.1**

(22) Date of filing: **22.09.2004**

(54) **Method and device for digitally measuring the phase of a signal**

Verfahren und Vorrichtung zur digitalen Phasenmessung eines Signals

Procédé et dispositif pour la mesure de la phase d'un signal

(84) Designated Contracting States:
**AT BE BG CH CY CZ DE DK EE ES FI FR GB GR
HU IE IT LI LU MC NL PL PT RO SE SI SK TR**

(43) Date of publication of application:
**29.03.2006 Bulletin 2006/13**

(73) Proprietor: **Alcatel Lucent
75008 Paris (FR)**

(72) Inventors:
• **Skerlj, Maurizio
34100 Trieste (IT)**

• **Razzetti, Luca
20099 Sesto San Giovanni (Milano) (IT)**
• **Gastaldello, Stefano
35037 Teolo (Padova) (IT)**

(74) Representative: **Schmidt, Werner Karl
Alcatel Lucent
Intellectual Property & Standards
70430 Stuttgart (DE)**

(56) References cited:
**EP-A- 0 446 190    EP-A- 0 637 137
DE-A1- 4 336 240    US-B1- 6 246 738
US-B1- 6 266 799**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

The present invention relates to the field of telecommunication networks and, in particular, to a method and a device for digitally measuring the phase of a signal.

It is known that in a synchronous transmission network, e.g. SDH or Sonet, all the local timing signals are synchronized by a reference timing signal. Said reference timing signal propagates across the entire network and it is employed to synchronize all the nodes of the transmission network.

In other words, a synchronous transmission network implements a "master-slave" synchronization scheme, wherein all the local timing signals (slave) of the single network nodes are recovered by locally regenerating a reference timing signal (master), which propagates across the network through the data flows.

In order to be synchronised, a network element of a synchronous network (e.g. SDH or Sonet) is required to perform functions such as measurement of the reference frequency or regeneration of the reference timing signal. For a proper operation of the network, such functions must be performed by each network element as accurately as possible.

For instance, the ITU-T Recommendation G.813 for SDH standard establishes the requirements of the frequency of the reference timing signal measured by each network element. For instance, the accuracy is fixed to 4,6 ppm for a 2048 kbit/s-operation optimised SDH hierarchy. The ITU-T Recommendation G.813 also defines the requirements of the locally-regenerated timing signals ("Slave Equipment Clock" or SEC), as a function of wander and jitter of the recovered signal phase. For instance, the maximum wander is 40 ns over a 0,1-1 s observation interval, while the maximum jitter is defined by a maximum peak-to-peak amplitude of 0,50 UI over a 60 s interval with a band-pass filter having a 20 Hz-100 KHz passing band, for a 2048 kbit/s-operation optimised SDH hierarchy.

Devices for phase measurement are known in the art, which can recover the phase of a signal both digitally or analogically. Said devices recover the phase as a function of time $\Gamma x(t)$ of an incoming signal $x(t)$ and, optionally, they estimate its frequency $fx$ by suitably processing the phase. In a synchronous transmission network, said devices for phase measurement can be employed into the network elements:

- for recovering the phase and/or frequency of an incoming signal $x(t)$;
- for contributing to the regeneration of an incoming signal $x(t)$.

It has to be noticed that timing signals propagate across the network through data flows having bit-rate equal to the frequency of the timing signals. For simplicity, in the following description "signal $x(t)$ with frequency $fx$" will indicate a data flow with bit-rate $fx$.

In the first case (phase and/or frequency measurement), a device for phase measurement receives a signal $x(t)$ and outputs, for example, the measurement of its frequency $fx$. In a network element, said device may for instance provide a measurement of the phase or frequency of the reference timing signal contained in the synchronous data flow; alternatively, said device may provide a measurement of the phase or frequency of an asynchronous data flow coming from asynchronous local networks connected to the synchronous network. In the first case ($fx$ is the reference timing frequency), the measured frequency for example can be stored by the network element which can use it in case of need, for example when the network element eventually looses all the reference timing signals ("holdover operation" in SDH Recommendation ITU-T G.813). In the second case ($fx$ is the frequency of an asynchronous signal), the measured frequency can be used to perform mapping/demapping of asynchronous tributaries into the synchronous numerical structures.

As mentioned above, devices for phase measurement can contribute to the regeneration of an incoming signal $x(t)$. Among regeneration devices, the Phase Locked Loop (or PLL) is one of the most widespread, thanks to the simplicity of its structure and the accuracy of the regenerated signal. A PLL receives a signal $x(t)$ with a frequency $fx$ and, by a proper feedback mechanism, the PLL outputs a local periodic signal $xloc(t)$ having the same frequency $fx$ of the signal $x(t)$. In greater details, a PLL comprises a Phase Detector device and a Voltage Controlled Oscillator (or VCO) in a feedback configuration. The Phase Detector compares the phase of the incoming signal $x(t)$ to the phase of the local signal $xloc(t)$ generated by the VCO and propagating into the loop of the PLL. The phase error signal between the two compared signals is used to modify the operation frequency of the VCO. The PLL is "phase-locked" when the frequency of the local signal $xloc(t)$ is equal to the frequency of the incoming signal $x(t)$.

For instance, in a synchronous network PLLs are placed into the network elements to recover a local timing signal ($xloc(t)$) from the synchronous data flow ($x(t)$). The local timing signal can then be used to synchronise the switching functions.

As mentioned above, the devices for phase measurement can be digital or analog. For transmission network application, however, devices for phase measurement are preferably digital, for an easier integration with the other components of the network element, which mainly perform digital signal processing.

A known method for digitally measuring the phase $\Gamma x(t)$ of a signal $x(t)$ provides a counter which evolves at each event marking the evolution of the signal $x(t)$. Afterwards, the counter is sampled at a sampling frequency $fs$. Ideally, if the frequency fs is equal to an integer sub-multiple of the frequency fx, the sample sequence allows to recover the phase as a function of time $\Gamma x(t)$.

Nevertheless, in real operations the frequency fs is not exactly an integer sub-multiple of the frequency fx. For instance, the incoming signal x(t) may be an asynchronous data flow, whose frequency significantly differs from the synchronous frequencies synchronizing the network element, from which the frequency fs is derived. Alternatively, the incoming signal x(t) may be a synchronous data flow, whose bit-rate is affected by the aforementioned tolerance compliant with the Recommendation ITU-T G.813 (a few parts per million).

In these cases, wherein a detuning occurs between the sampling frequency fs and the signal frequency fx, the measured phase is affected by a periodic error, for reasons which will be explained in details herein after. The period of the phase error increases by decreasing the detuning between fs and fx. For instance, with formulas that will be reported herein after, it is shown that when measuring the phase of an asynchronous signal with a frequency of the synchronous hierarchy (detuning of a few percentage points), the oscillation has a period of a few nanoseconds, corresponding to a spectral distribution of the order of 100 MHz, which is rather easy to filter. On the contrary, when measuring the phase of a synchronous signal through a frequency of the synchronous hierarchy (detuning of a few parts per million), the phase error has a period of a few seconds, corresponding to a spectral distribution in the Hz range, which cannot be filtered by a digital low-pass filter.

EP0446190 discloses an electrical circuit for producing a digital value which is representative of instantaneous phase of an electrical input signal relative to a reference frequency signal. The circuit includes a digital counter, a trigger unit, an intermediate register and a correcting circuit for correcting a resulting numerical value in the intermediate register by removing an accumulating phase offset value.

US6246738 describes a phase detector for controlling a phase locked loop having a voltage controlled oscillator, comprising a counter clocked by a clock signal produced by the voltage controlled oscillator, a latch, a phase modulator and an accumulator.

The general object of the present invention is to provide a method and a device for digitally measuring the phase of a data signal in a transmission network which overcomes the aforesaid problem.

In particular, an object of the present invention is to provide a method and a device for digitally measuring the phase of a data signal in a transmission network in which the phase error due to the detuning between the sampling frequency and the frequency of the signal under measurement has a spectral distribution which is independent from said detuning and which can be easily filtered by low-pass digital filters. Conveniently, such digital filters are similar to those already present into the network elements of a synchronous network.

This and other objects are achieved, according to the present invention, by a method of digital measurement of phase of a data signal in a transmission network according to claim 1, and by a device according to claim 5. Further advantageous features of the present invention are set forth into the respective dependent claims. All the claims are deemed to be an integral part of the present description.

According to the present invention, a method for digitally measuring the phase of a signal is provided, said method including an additional step compared with the known method, wherein the counter is sampled at a first sampling frequency uncorrelated from the frequency of the data signal. Said first sampling frequency can be expressed as fc= $\alpha$ fx, where $\alpha$ is an irrational number. With formulas which will be reported herein after, it is shown that the period and the amplitude of the phase error mainly depends on $\alpha$ ; in particular, if $\alpha$ is an irrational number, the phase error is aperiodic.

Therefore, even though the detuning between fs and fx is of only a few parts per million, the phase error can be modified, as it now mainly depends on $\alpha$. In particular, $\alpha$ can be chosen in order to shift the spectral distribution of the phase error towards a frequency range which can be easily filtered by an electronic low-pass filter.

In a first aspect the present invention provides a method for digitally measuring the phase of a data signal with frequency fx travelling in a transmission network. The method comprises the following steps: providing a counter; increasing the value of the counter upon each occurrence of an event marking the evolution of the data signal with frequency fx; sampling the counter at a first sampling frequency fc uncorrelated from the frequency fx, thus obtaining a first sample sequence; sampling the first sample sequence at a second sampling frequency fs, thus obtaining a second sample sequence; and digitally processing said second sample sequence in order to estimate said phase of said data signal. The method is characterised in that the counter is sampled at a frequency fc with fc= $\alpha \cdot$ fx, where $\alpha$ is an irrational number.

Preferably, the step of digitally processing said second sample sequence comprises digitally filtering said second sample sequence.

Advantageously, said frequency fx of said data signal and said second sampling frequency fs are frequencies of a synchronous transmission system.

Preferably, said first sampling frequency fc is generated by a local oscillator independent from said frequency fx and from said second sampling frequency fs.

In a second aspect the present invention provides a device for digitally measuring the phase of a data signal with frequency fx travelling in a transmission network. The device comprises: a counter block, said counter block increasing a value of a counter upon each occurrence of an event marking the evolution of the data signal with frequency fx; a register, said register sampling the counter at a first sampling frequency fc uncorrelated from said frequency fx, thus obtaining a first sample sequence; a sampler for sampling the first sample sequence at a second sampling frequency fs, thus obtaining a second sample sequence; and a processor for digitally processing the second sample sequence in order to estimate the phase of the data signal. The device is characterised in that the register is a register sampling the counter at a first sampling frequency fc with fc=$\alpha$·fx, where $\alpha$ is an irrational number.

Preferably, the processor digitally processes the second sample sequence by digitally filtering the second sample sequence.

Advantageously, said device is a part of a Phase Locked Loop. Advantageously, said device is comprised in a network element.

Further features and advantages of the present invention will become clear from by the following detailed description, given by way of example and not of limitation, to be read with reference to the accompanying drawings, wherein:

- Figure 1 shows a graph of a periodic signal x(t) with frequency fx;
- Figure 2 shows a graph of the normalised phase $\Gamma x(t)/2\pi$ of the signal x(t) and of the counter c(t) according to the known method;
- Figure 3 shows a graph of the normalised phase $\Gamma x(t)/2\pi$ of the signal x(t), of the counter c(t) and of the sample sequence $\{s_n\}$ according to the known method, in an ideal case in which fs is an integer sub-multiple of fx;
- Figures 4a and 4b show graphs of the normalised phase $\Gamma x(t)/2\pi$ of the signal x(t), of the counter c(t) and of the sample sequence {sn} according to the known method, in a real case in which fs is respectively higher (Figure 4a) and lower (Figure 4b) than an integer sub-multiple of fx;
- Figure 5 shows a graph of the normalised phase $\Gamma x(t)/2\pi$, of the counter c(t) and of the sample sequence $\{S_n\}$ and a graph of the phase error $\varepsilon(t)$ and of the phase error sequence $\{\varepsilon_n\}$ according to the known method, in an ideal case in which fs is an integer sub-multiple of fx;
- Figure 6a e 6b show a graph the normalised phase $\Gamma x(t)/2\pi$, of the counter c(t) and of the sample sequence $\{s_n\}$ and a graph of the phase error $\varepsilon(t)$ and of the phase error sequence $\{\varepsilon_n\}$ according to the known method, in real cases wherein fs is respectively higher (Figure 6a) and lower (Figure 6b) than an integer sub-multiple of fx;
- Figure 7 shows a graph of the phase error $\varepsilon(t)$, of the phase error sequence $\{\varepsilon_{n'}\}$ in the ideal case (fs equal to an integer sub-multiple of fx), of the phase error sequence $\{\varepsilon_{n''}\}$ in a real case (detuning between fs and fx) according to the known method, and of the phase error sequence $\{\varepsilon_{n'''}\}$ in a real case (detuning between fs and fx) according to the invention;
- Figure 8 shows the scheme of a known device for digital measurement of the phase of a signal;
- Figure 9 shows the scheme of a device for digital measurement of the phase of a signal according to the present invention; and
- Figure 10 shows a PLL comprising a device for digital measurement of the phase of a signal according to the present invention.

In all the graphs representing a variable as a function of time (x(t), c(t), etc ...), the time scale is represented in arbitrary units.

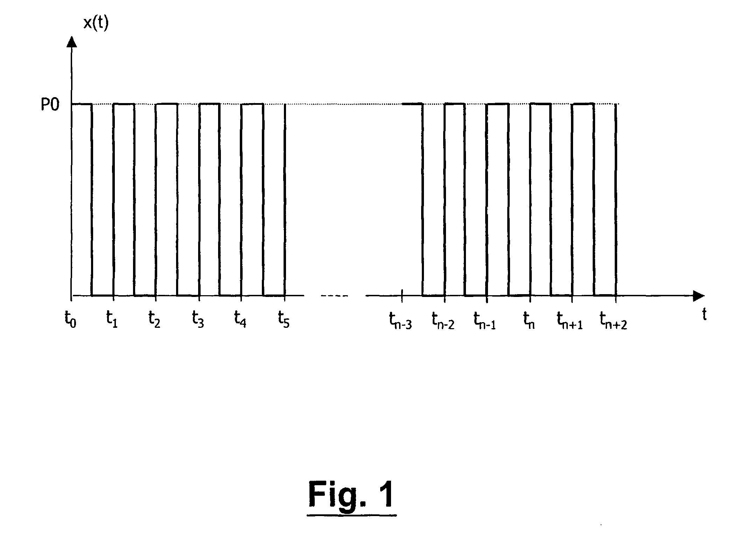

Figure 1 shows a graph of a periodic signal x(t) with amplitude P0 and frequency fx. The signal x(t) exhibits a rising edge at each instant $t_1, t_2, ... t_n$, where $t_1$=1/fx, $t_2$=2/fx, ... $t_n$=n/fx. In other words, each period of the periodic signal x(t) starts with a rising edge.

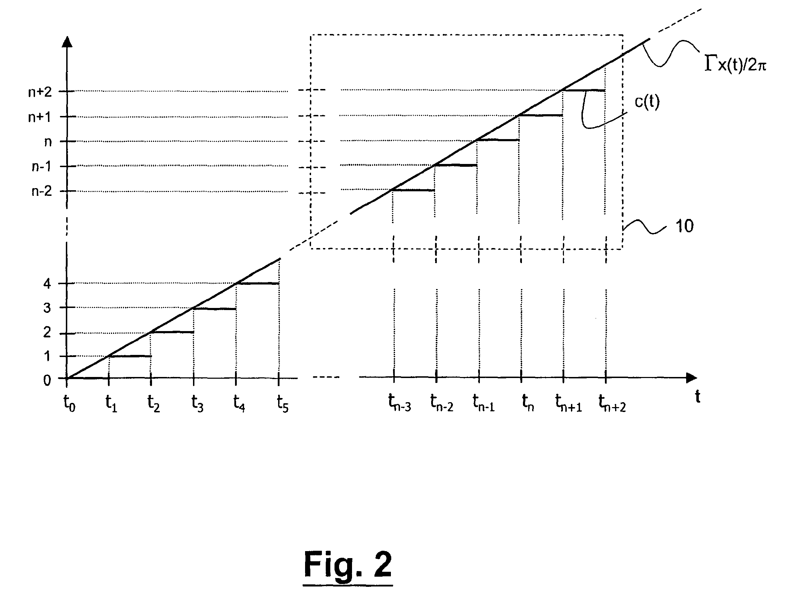

It is known that the phase $\Gamma x(t)$ of the periodic signal x(t) evolves in time according to the relation $\Gamma x(t) = 2\pi$·fx·t, i.e. $\Gamma x(t)$ is equal to an integer multiple of $2\pi$ in the time instants $t_1, t_2, ... t_n$. Thus, in the time instants $t_1, t_2, ... t_n$, wherein raising edges of the periodic signal x(t) occur, the normalised phase $\Gamma x(t)/2\pi$ of the signal x(t) is equal to an integer value, as shown in Figure 2. In particular, $\Gamma x(t_1)/2\pi$=1, $\Gamma x(t_2)/2\pi$=2, ... $\Gamma x(t_n)/2\pi$=n.

As mentioned above, in a known method for digitally measuring the phase of a signal, a counter is firstly provided. The counter value is increased upon each occurrence of an event marking the evolution of the data signal. Figure 2 shows for example a counter c(t) which is increased at each rising edge of the periodic signal x(t). Hence:

- c(t)=0 where $t_0$<t<$t_1$;
- c(t)=1 where $t_1$<t<$t_2$;
- c(t)=2 where $t_2$<t<$t_3$; and, in general,
- c(t)=n where $t_n$<t<$t_{n+1}$.

Comparing the normalised phase $\Gamma x(t)/2\pi$ with the counter c(t), it can be noticed that in each period the value of the counter c(t) is the integer part of the normalised phase $\Gamma x(t)/2\pi$. Thus, the counter c(t) is equal to the normalised phase $\Gamma x(t)/2\pi$ with a phase error $\varepsilon(t)$. The phase error $\varepsilon(t)$ is the fractional part of the normalised phase $\Gamma x(t)/2\pi$ and it

is defined as s(t)= Γx(t)/2π-c(t).

It has to be noticed that, in the present description, x(t) is a periodic signal. Nevertheless, as mentioned above, the method of measurement according to the present invention can be applied to data signals, i.e. to signals which comprise a sequence of bit with bit-rate fx. To perform a digital measurement of the phase of this kind of signals, each bit "1" or "0" must be encoded so that in each period there occurs an event for incrementing the counter c(t). It is the case, for example, of bipolar encodings, wherein the bit "1" is encoded as a "high-low" transition and the bit "0" is encoded as a "low-high" transition. Therefore, independently of the bit sequence, each period includes a transition; the counter c(t) is then increased each time a transition occurs.

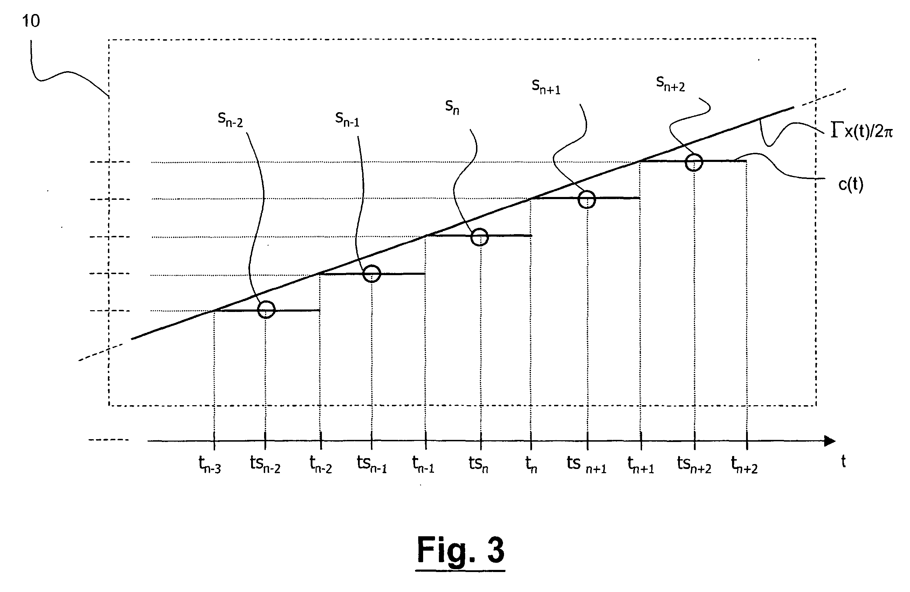

The next step of the known method for measuring the phase of the signal x(t) comprises sampling the counter c(t) at a sampling frequency fs, i.e sampling the counter c(t) at a sequence of time instants $\{ts_n\}$ of sampling instants $ts_1$, $ts_2$, ... $ts_n$. Two consecutive sampling instants $ts_n$ e $ts_{n+1}$ are spaced by a sampling period Ts=1/fs. A sample sequence $\{s_n\} = s_1, s_2, ... s_n$ is thus obtained. In particular, referring to Figure 3:

- at $ts_{n-2}$ : $s_{n-2}=c(ts_{n-2})$;
- at $ts_{n-1}$ : $s_{n-1}=c(ts_{n-1})$;
- at $ts_n$ : $s_n=c(ts_n)$;
- at $ts_{n+1}$ : $s_{n+1}=c(ts_{n+1})$; and
- at $ts_{n+2}$ : $S_{n+2}=c(ts_{n+2})$.

As already mentioned, the counter c(t) is the normalised phase Γx(t)/2π affected by an error ε(t). However, if the sampling frequency fs is such that the sampling instants always occur in the same position relatively to the signal periods, the phase error affecting each sample of the sequence $\{s_n\}$ is the same for all the samples. In other words, if the sampling frequency fs is equal to fx or to an integer sub-multiple of the frequency fx, the sequence $\{s_n\}$ allows to recover the normalised phase Γx(t)/2π, shifted by a phase offset.

In the following, for clarity reasons, only the case with sampling frequency fs equal to the frequency fx will be treated. Nevertheless, all the considerations may be applied to the more general case with fs integer sub-multiple of fx.

Figure 3 shows an ideal case, in which fs is exactly equal to fx. It can be noticed that all the sampling instants are placed in the middle of each period; therefore, the sample sequence $\{s_n\}$ is a ramp, which is analogous to the normalised phase Γx(t)/2π ramp, shifted by a constant phase offset.

However, in real cases fs is not exactly equal to fx (or to an integer sub-multiple of fx). For instance, in synchronous networks, the frequency fs is derived from the reference timing signal, thus being a sub-multiple of one of the synchronous hierarchy frequencies. The signal x(t) may be either a synchronous signal, or an asynchronous signal. As mentioned before, in the first case the detuning between fs and fx may be of a few parts per million; in the second case, the detuning between fs and fx may be of a few percentage points.

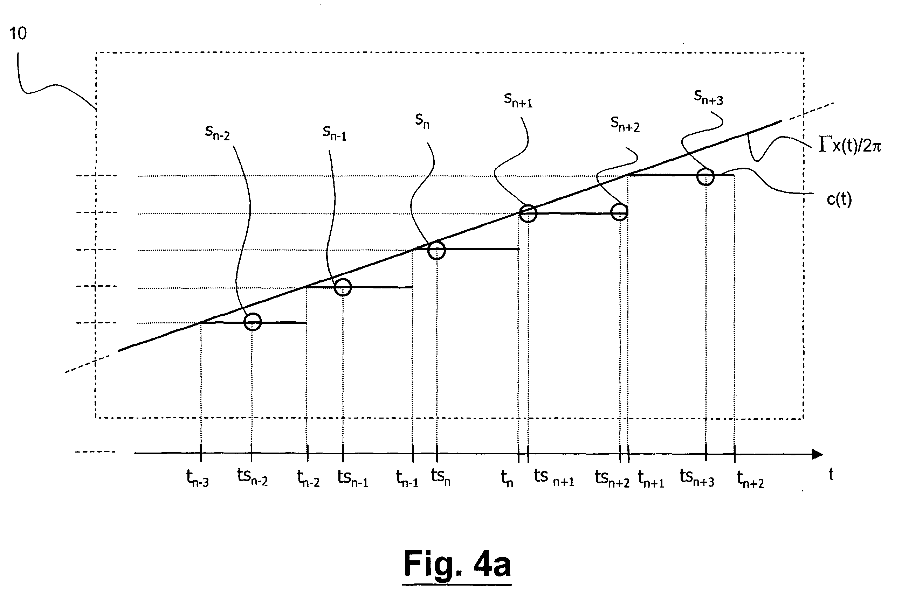

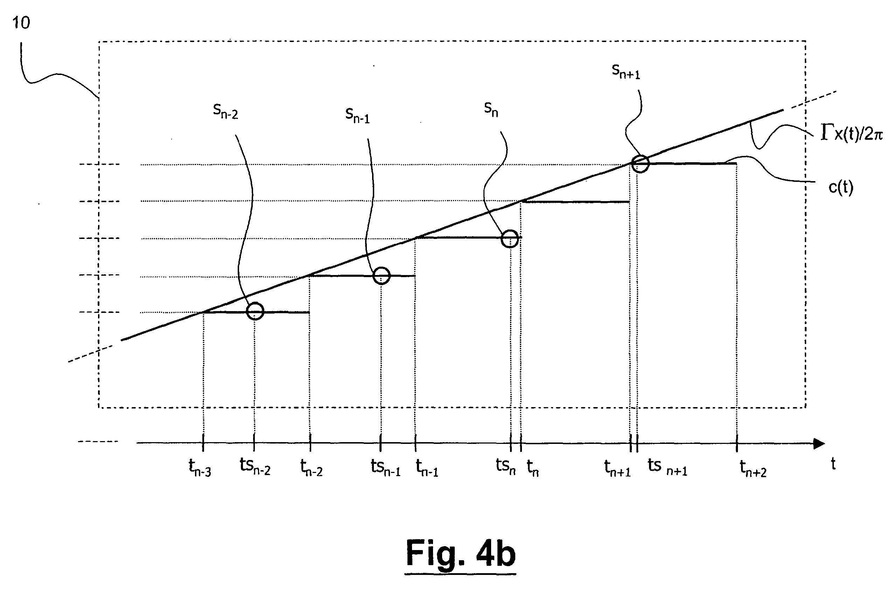

Figures 4a and 4b show the effect of sampling in two real cases, wherein the sampling frequency fs and the frequency fx are detuned. In particular, Figure 4a refers to the case wherein fs is higher than fx. It is assumed that in a certain signal period, for example the period comprised between $t_{n-3}$ e $t_{n-2}$, the sampling instant $ts_{n-2}$ is placed in the middle of the period. As fs is higher than fx, in the following signal periods the sampling instants will tend to move towards the beginning of the period. Therefore, each sample of the sequence $\{S_n\}$ is affected by a phase error, with respect to the normalised phase Γx(t)/2π, that changes for each sample. Besides, as the sampling period 1/fs is lower than the signal period, after a certain number of sampling instants there will be a signal period (between $t_n$ e $t_{n+1}$ in Figure 4a) comprising two sampling instants ($ts_{n+1}$ e $ts_{n+2}$). The resulting sample sequence $\{s_n\}$ thus exhibits an anomaly with respect to the linear trend of the normalised phase ramp.

Similarly, Figure 4b shows the case wherein fs is lower than fx. Also in this case, in a certain signal period, for instance the one included between $t_{n-3}$ e $t_{n-2}$, the sampling instant is placed exactly in the middle of the signal period. As fs is lower than fx, the following sampling instants tend to move toward the end of the signal period. Hence, each sample of the sequence $\{S_n\}$ is affected by a different phase error. Besides, as the sampling period 1/fs is higher than the signal period, after a certain number of sampling instants there will be a signal period (between $t_n$ e $t_{n+1}$ in Figure 4b) comprising no sampling instants. The resulting sample sequence $\{S_n\}$ thus exhibits an anomaly with respect to the linear trend of the normalised phase ramp.

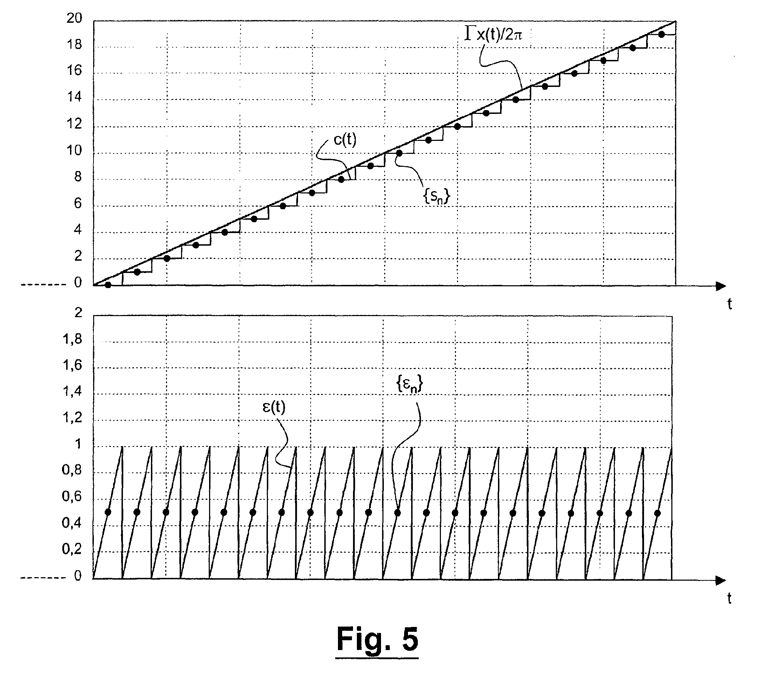

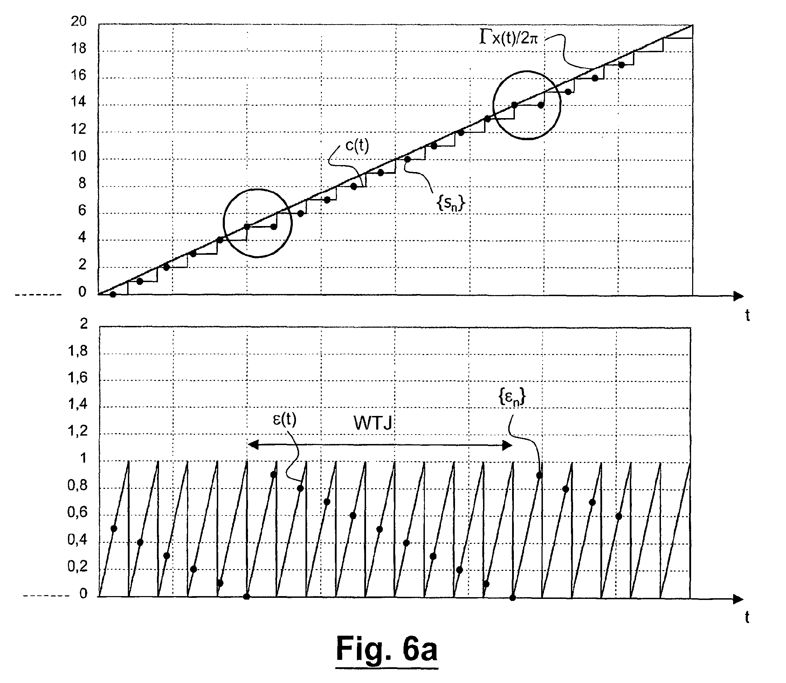

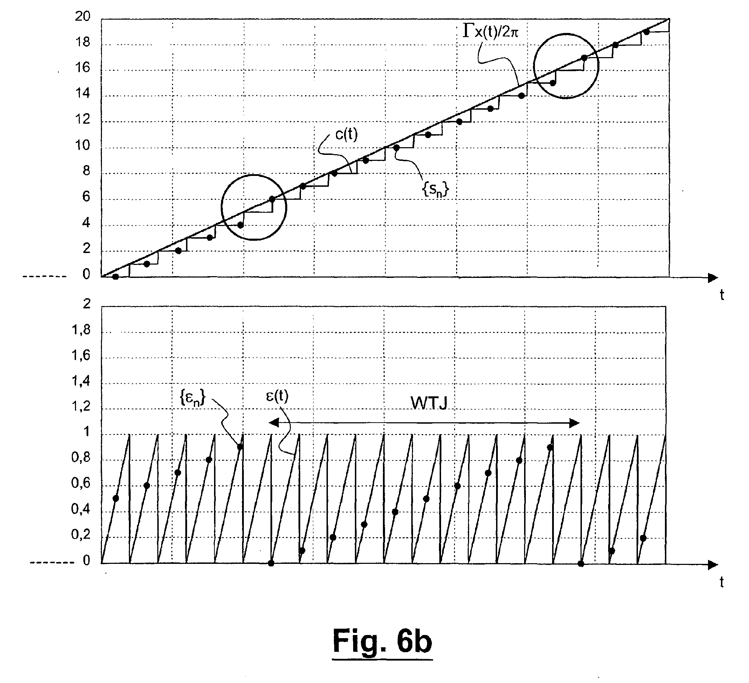

Figures 5, 6a and 6b show the effect of the detuning between fs and fx over the phase error occurring when considering at each sampling instant $ts_n$ the sample $s_n$ instead of the actual value of normalised phase Γx($ts_n$)/2π, according to the known method. In particular, Figure 5 is referred to the ideal case wherein fs is equal to fx. Figures 6a and 6b are referred to two real cases wherein fs is respectively higher and lower than fx.

In Figure 5, it can be noticed, as mentioned by reference to Figure 3, that the sample sequence $\{S_n\}$ has a linear trend, thus corresponding, except a phase offset, to the signal normalised phase. In other words, as shown in the lower graph of Figure 5, in this case the sequence of phase errors $\{\varepsilon_n\}$ affecting the sequence $\{s_n\}$, wherein each $\varepsilon_n$ is defined as $\varepsilon_n = $ Γx($ts_n$)/2π - $s_n$, is constant.

Figure 6a shows a real case in which fs is higher than fx. In this case, the sample sequence $\{s_n\}$ exhibits anomalies, as described by reference to Figure 4a. Such anomalies (highlighted by circles in Figure 6a) are periodic with a period WTJ. In other words, as shown in the lower graph of Figure 6a, in this case the sequence of phase errors $\{\varepsilon_n\}$ has a saw-tooth shape with period WTJ. Filtering such a phase error thus requires filtering a 1/WTJ frequency component.

Figure 6b shows a second real case in which fs is lower than fx. In this case, the sample sequence $\{s_n\}$ exhibits anomalies, as described by reference to Figure 4b. Such anomalies (highlighted by circles in Figure 6b) are periodic with a period WTJ. In other words, as shown in the lower graph of Figure 6b, in this case the sequence of phase errors $\{\varepsilon_n\}$ has a saw-tooth shape with period WTJ. Filtering such a phase error thus requires filtering a 1/WTJ frequency component.

It is possible to estimate the period WTJ of the sequence of phase errors through the formulas reported herein after.

Under the assumption that fs can be expressed as fs=(1+s)·fx, in each period of the signal x(t), each sampling instant $ts_n$ moves, relatively to the corresponding signal period, of a time interval

$$\Delta T = s/fx.$$

The number of signal periods required by the time instant to move across the entire signal period is

$$N = (1/fx)/\Delta T.$$

Hence, an anomaly will occur when the sampling instant has passed through the whole period of the signal x(t), i.e.

$$WTJ = (1/fx) \cdot N = 1/(fx \cdot s).$$

For instance, it is assumed that fs equal to 77 MHz. If the signal x(t) is a synchronous signal, s is equal to a few parts per million, according to the ITU-T Recommendation G.813. Thus,

$$WTJ(synch) = 1/ (77\ MHz \cdot 10^{-6}) = 12\ ms.$$

Digitally filtering such an anomaly requires filtering a spectral distribution placed at 1/ WTJ(synch) = 77 Hz. It is clear that such a filtering cannot be performed by a low-pass digital filter, as the frequency is too low.

On the other hand, it is not possible to modify the sampling frequency fs, as it is derived by the synchronous hierarchy frequencies by means of dividers, which provides integer sub-multiples of fs. Using a sub-multiple of fs, however, does not eliminate anomalies of the sequence $\{s_n\}$ and the consequent periodicity of the sequence of phase errors $\{\varepsilon_n\}$.

According to an example, a method for digitally measuring the phase of a signal is provided, wherein the spectral distribution of the phase error can be modified. Hence, the method according to the invention comprise an additional step with respect to the known method, wherein the counter c(t) is sampled at a first sampling frequency fc uncorrelated from the signal frequency fx, thus obtaining a first sample sequence $\{c_n\}$. Said first sample sequence $\{c_n\}$ is in turn sampled at a second sampling frequency fs, thus obtaining a second sample sequence $\{s_n\}$, which is finally digitally processed.

With the method according to the invention, even though the detuning between fs and fx is very low, as in synchronous transmission system applications, the second sequence $\{S_n\}$ exhibits anomalies with respect to the ramp of the normalised phase with a period WTJ mainly dependent on the ratio between the first sampling frequency fc and the signal frequency fx. In particular, if fc = $\alpha$ fx, with $\alpha$ irrational number, by suitably tailoring $\alpha$ it is possible to modify the sequence of phase errors $\{\varepsilon_n\}$.

Actually, if $\alpha$ is an irrational number (i.e. fs and fx are uncorrelated), the sequence of phase errors $\{\varepsilon_n\}$ becomes aperiodic. As mentioned referring to Figures 6a and 6b, if the ratio between fs and fx is a fractional value the anomalies of the sample sequence are periodic. On the contrary, as $\alpha$ is an irrational number, anomalies of the sample sequence $\{C_n\}$ are not exactly periodic, as each sample $c_n$ which immediately follows an anomaly falls in a different position relatively to the signal period. Hence, anomalies are not exactly periodic in time, so the amplitude of the spectral distribution of the sequence of phase errors $\{\varepsilon_n\}$ is reduced.

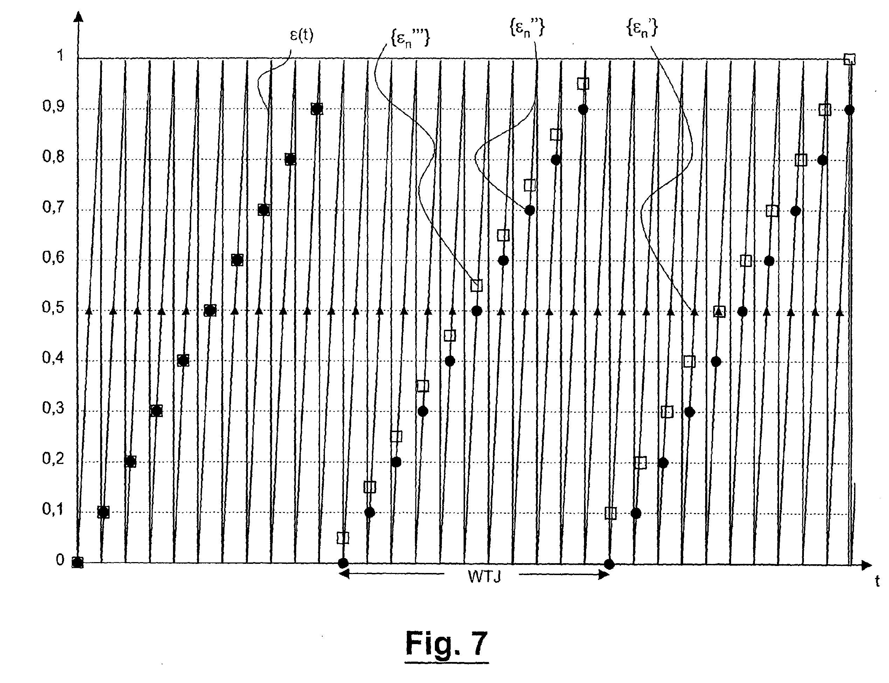

For a deeper understanding of the invention, reference can be made to the above mentioned phase error $\varepsilon(t)$. Reference will be now made to Figure 7, wherein a graph of the error as a function of time $\varepsilon(t)$ is reported. The error $\varepsilon(t)$, defined as $\varepsilon(t) = \Gamma x(t)/2\pi - c(t)$, has a periodic saw-tooth shape. The sequence $(\varepsilon_{n'})$, represented by triangles in Figure 7, is the sequence of phase errors affecting the sequence $\{s_n\}$ in the ideal case, wherein fs is equal to fx. As already mentioned, each phase error $\varepsilon_{n'}$ affecting each sample $s_n$ is constant, the sequence $\{s_n\}$ thus corresponding to the normalised phase shifted by an offset. The sequence $\{\varepsilon_{n''}\}$, represented in Figure 7 by circles, is the sequence of phase errors affecting the sequence $\{s_n\}$ in a real case, wherein fs and fx are detuned. In this case, the phase error $\varepsilon_{n''}$ affecting each sample $s_n$ is not constant, and the sequence $\{\varepsilon_{n''}\}$ has period WTJ.

The sequence $\{\varepsilon_{n'''}\}$, represented in Figure 7 by squares, is the sequence of phase errors affecting the sequence $\{s_n\}$ in an embodiment of the method according to the present invention. As already mentioned, the sequence $\{\varepsilon_{n'''}\}$ is not periodic, since the sampling time instants always fall in different positions of the signal period. In the following, the formulas describing $\{\varepsilon_{n'''}\}$ will be derived.

For simplicity, it will be assumed that $\alpha$ is an irrational number close to a fractional number q/p. Therefore Tc = p/q·Tx, while Ts = (1+d) Tx. Sampling the phase error $\varepsilon(t)$ with a first sampling period Tc and then with a second sampling period Ts, the sequence $\{\varepsilon_{n'''}\}$ can be expressed as:

$$\{\varepsilon_n{'''}\} = \frac{nTs}{Tx} - \left\lfloor \frac{Tc}{Tx} \left\lfloor \frac{nTs}{Tc} \right\rfloor \right\rfloor = n(1+d) - \left\lfloor \left\lfloor \frac{qn(1+d)}{p} \right\rfloor \frac{p}{q} \right\rfloor$$

where

$$n = \lfloor t \cdot fs \rfloor$$

and where $\lfloor \cdot \rfloor$ is the integer operator. The ratio p/q can be expressed as p/q = (m+1)/m; the previous formula thus can be rewritten as:

$$\{\varepsilon_n{'''}\} = nd - \left\lfloor \left\lfloor \frac{mn}{m+1} + \frac{ndm}{m+1} \right\rfloor \frac{m+1}{m} - n \right\rfloor.$$

As d is in general very low, the term nd can be considered as a constant K. Therefore, the sequence of phase errors can be expressed as:

$$\{\varepsilon_n{'''}\} = K - \left\lfloor \left\lfloor \frac{mn}{m+1} + \frac{Km}{m+1} \right\rfloor \frac{m+1}{m} - n \right\rfloor.$$

It is now possible to demonstrate that the sequence of phase errors, when filtered, is substantially independent from K, i.e. from d; in other words, the sequence of phase errors is independent from the detuning between fs and fx. By digitally filtering the sequence $\{\varepsilon_{n'''}\}$, the filtered sequence $\{\varepsilon_{n'''}\}^{filt}$ can be written as:

$$\{\varepsilon_i{'''}\}^{filt} = \frac{1}{m+1} \sum_{n=1}^{m+1} \varepsilon_{n+i(m+1)} = K - \frac{1}{m+1} \sum_{n=1}^{m+1} \left\lfloor \left\lfloor \frac{nm}{m+1} + \frac{Km}{m+1} \right\rfloor \frac{m+1}{m} - n \right\rfloor.$$

As the term of the summation is a periodic function with period m+1, it is possible to eliminate the dependence on i. Rewriting K as K=k+$\gamma$, where k is the integral part of k and $\gamma$ is the fractional part of K, the filtered sequence can be further expressed as:

$$\{\varepsilon_i'''\}^{filt} = \gamma - \frac{1}{m+1} \sum_{n=1}^{m+1} \left[ \left\lfloor \frac{nm}{m+1} + \frac{\gamma m}{m+1} \right\rfloor - n + \left\lfloor \frac{nm}{m+1} + \frac{\gamma m}{m+1} \right\rfloor \frac{1}{m} \right].$$

It can be noticed that the first two terms of the summation are always integer numbers, while the third term provides a fractional number. The third term is an integer number only when multiplied by a number higher than m, i.e. the two following conditions must be satisfied:

-   $nm+\gamma m \geq m(m+1)$; and
-   $n \geq m+(1-\gamma)$.

Both these conditions are satisfied only when n=m+1, and, in this case, the third term is equal to 1. The filtered sequence can then be rewritten as:

$$\{\varepsilon_i'''\}^{filt} = \gamma - \frac{1}{m+1} \left\{ 1 + \sum_{n=1}^{m+1} \left\lfloor n + \frac{\gamma m - n}{m+1} \right\rfloor - \sum_{n=1}^{m+1} n \right\}.$$

It can be noticed that:

-   $\left\lfloor n + \dfrac{\gamma m - n}{m+1} \right\rfloor = n$ when $n \leq \gamma m$, while

-   $\left\lfloor n + \dfrac{\gamma m - n}{m+1} \right\rfloor = n - 1$ when $n > \gamma m$.

The final expression of the filtered sequence of phase errors is then:

$$\{\varepsilon_i'''\}^{filt} = \frac{m}{m+1} + \left( \gamma - \frac{\lfloor \gamma m \rfloor}{m+1} \right)$$

It can be noticed that the filtered sequence $\{\varepsilon_n'''\}^{filt}$ depends on m, which is related to the ratio between the first sampling frequency fc and the signal frequency fx. The weak dependence of the sequence on d is expressed by the term $\gamma$. It can also be noticed that while in the known method the phase error varies in a 0-1 range, in the method according to the present invention the maximum value of the phase error is about 2/m.

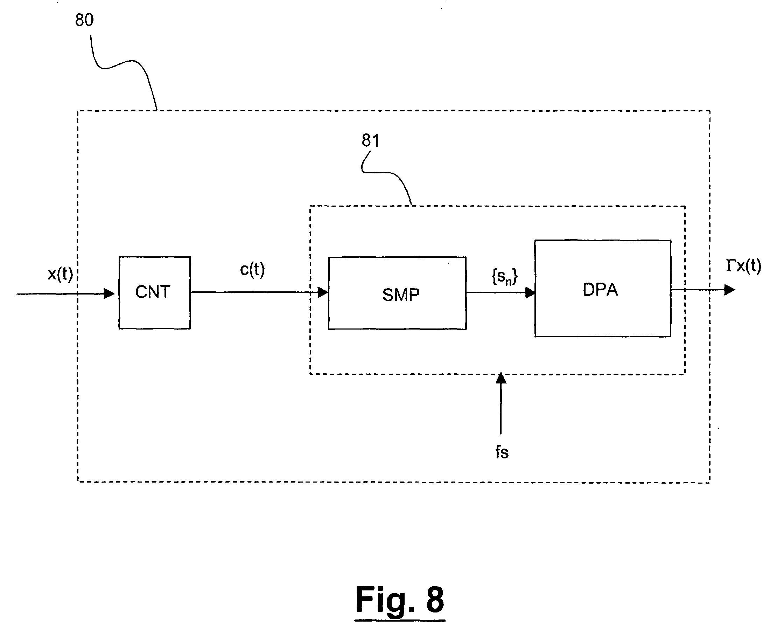

Figure 8 shows a known device for digitally measuring the phase of a signal. The device 80 comprises a counter block CNT, with an input port for receiving a signal, and an output port connected to the input port of a digital device 81, in turn comprising a sampler SMP connected to a processor DPA, which implements a digital processing algorithm. A signal x(t) at the input of the device 80 is received from the counter CNT, which outputs a counter c(t). Said counter c(t) is sent to the digital device 81, which is synchronised by a timing signal with frequency fs. In the digital device 81, the counter c(t) is firstly sampled by the sampler SMP with the sampling frequency fs, thus obtaining a sample sequence $\{S_n\}$. The sampler then sends the sample sequence $\{S_n\}$ to the processor DPA, which digitally processes the sequence and possibly estimates the frequency of the input signal x(t).

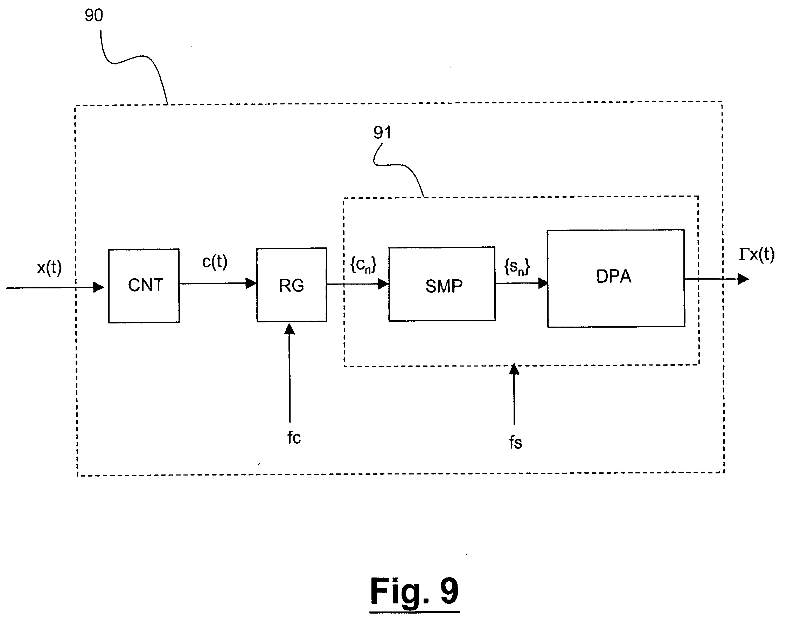

Figure 9 shows a device for digitally measuring the phase of a signal according to the present invention. Said device is advantageously employed into a network element of a synchronous transmission network. The device 90 comprises a counter block CNT, with an input port for receiving a signal and an output port connected to an input port of a register RG. The register RG has an output port which is connected to an input of a digital device 91, in turn comprising a sampler SMP connected to a processor DPA, which implements a digital processing algorithm. A signal x(t) at the input of the device 90 is received by the counter block CNT, which extrapolates a counter c(t) from the signal x(t). Said counter c(t) is sent to the register RG, which samples it at a first sampling frequency fc, thus obtaining a first sample sequence $\{C_n\}$. Said first sample sequence $\{C_n\}$ is sent to the digital device 91, which is synchronised by a timing signal with frequency fs. In the digital device 91, the sequence $\{C_n\}$ is firstly sampled by the sampler SMP with the sampling frequency fs, thus obtaining a sample sequence $\{S_n\}$. The sampler then sends the sample sequence $\{S_n\}$ to the processor DPA, which digitally processes the sequence and possibly estimates the frequency of the input signal x(t).

Such a device can be employed, for example, in network nodes of a synchronous network, as mentioned before. In this application, the frequency fs is obtained by a frequency of the synchronous hierarchy by suitable dividers, fs thus being an integer sub-multiple of a frequency of the synchronous hierarchy. On the contrary, fc is generated by a local oscillator uncorrelated from the timing signal available in the network element. This guarantees the uncorrelation between fc and fx.

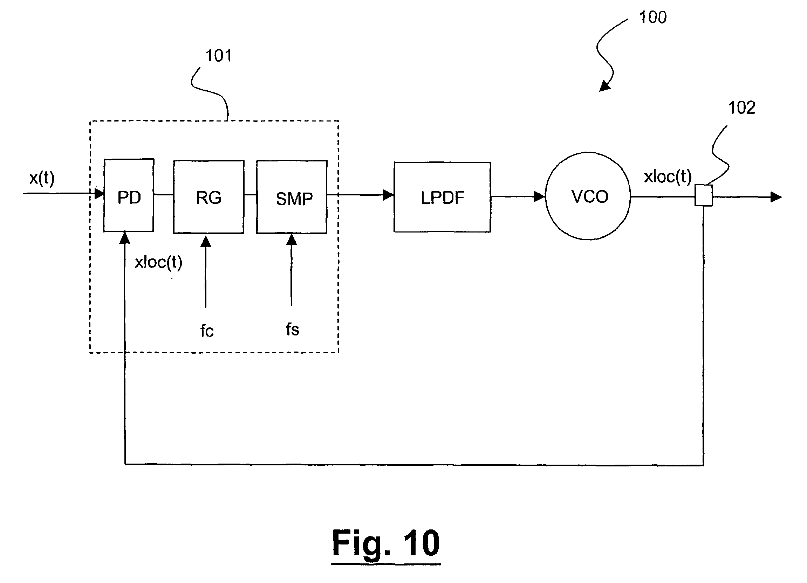

As mentioned in the introduction, the device for digitally measuring the phase according to the invention can be employed into a device for the regeneration of a periodic signal x(t), and, more in particular, into devices such as the so-called "Phase Locked Loop" (PLL). Figure 10 shows a PLL 100 wherein the phase recovery is performed according to the method of the present invention. The PLL 100 comprises a phase device for phase digital measurement 101, a low-pass digital filter LPDF and a voltage-controlled local oscillator VCO. At the output of the VCO, a junction 102 with two branches is provided, wherein a first branch is the output port of the PLL, while the second branch is connected to the device for phase digital measurement 101. The device for phase digital measurement 101 in turn comprises a phase detector PD, a register RG operating at a first sampling frequency fc and a sampler SMP working at a second sampling frequency fs.

A signal x(t) with frequency fx at the input of the PLL s compared by the phase detector PD with the local signal xloc(t) coming from the VCO through the second branch of the junction 102. The PD outputs a signal proportional to the phase difference between x(t) and xloc(t). The phase difference is firstly sampled by the register RG at the frequency fc, and then by the sampler SMP at the frequency fs. According to the present invention, the frequency fc is selected so that the sample sequence corresponding to the phase difference exhibits anomalies which can be easily filtered by the filter LPDF. The sample sequence corresponding to the phase difference is then digitally filtered by the filter LPDF. The filtered sequence is finally sent to the VCO. If this filtered sequence is different from a null sequence, the VCO modifies its operation frequency; if the filtered sequence is a null sequence, the phases of x(t) and xloc(t) are equal, and the VCO does not modify its operating frequency.

## Claims

1. Method for digitally measuring the phase ($\Gamma x(t)$) of a data signal (x(t)) with frequency fx travelling in a transmission network, said method comprising:

   - providing a counter (c(t));
   - increasing a value of said counter (c(t)) upon each occurrence of an event marking the evolution of the data signal (x(t)) with frequency fx;
   - sampling the counter (c(t)) at a first sampling frequency fc uncorrelated from said frequency fx, thus obtaining a first sample sequence ($\{c_n\}$),
   - sampling said first sample sequence ($\{c_n\}$) at a second sampling frequency fs, thus obtaining a second sample sequence ($\{s_n\}$); and
   - digitally processing said second sample sequence ($\{s_n\}$) in order to estimate said phase ($\Gamma x(t)$) of said data signal (x(t)),

   said method being **characterized in that** the step of sampling said counter (c(t)) at said first sampling frequency fc uncorrelated from said frequency fx is performed by sampling said counter (c(t)) at said frequency fc with fc=$\alpha$·fx, where $\alpha$ is an irrational number.

2. Method according to claim 1, wherein the step of digitally processing said second sample sequence ($\{s_n\}$) comprises digitally filtering said second sample sequence ($\{s_n\}$).

3. Method according to any of preceding claims, wherein said frequency fx of said data signal (x(t)) and said second sampling frequency fs are frequencies of a synchronous transmission system.

4. Method according to any of preceding claims, wherein said first sampling frequency fc is generated by a local oscillator independent from said frequency fx and from said second sampling frequency fs.

5. Device for digitally measuring the phase ($\Gamma x(t)$) of a data signal (x(t)) with frequency fx travelling in a transmission network, said device comprising:

- a counter block (CNT), said counter block (CNT) increasing a value of a counter (c(t)) upon each occurrence of an event marking the evolution of the data signal (x(t)) with frequency fx; and

- a register (RG), said register (RG) sampling the counter (c(t)) at a first sampling frequency fc uncorrelated from said frequency fx, thus obtaining a first sample sequence ($\{c_n\}$),

- a sampler (SMP), said sampler (SMP) sampling said first sample sequence ($\{c_n\}$) at a second sampling frequency fs, thus obtaining a second sample sequence ($\{s_n\}$); and

- a processor (DPA), said processor (DPA) digitally processing said second sample sequence ($\{s_n\}$) in order to estimate said phase ($\Gamma x(t)$) of said data signal (x(t)),

said device being **characterised in that** said register (RG) is a register sampling the counter (c(t)) at a first sampling frequency fc with fc=$\alpha\cdot$fx, where $\alpha$ is an irrational number.

6. Device according to claim 5, wherein said processor (DPA) digitally processes said second sample sequence ($\{s_n\}$) by digitally filtering said second sample sequence ($\{s_n\}$).

7. Device according to any of claims 5-6, wherein said frequency fx of the data signal (x(t)) and said second sampling frequency fs are frequencies of a synchronous transmission system.

8. Device according to any of claim 5-7, wherein said first sampling frequency fc is generated by a local oscillator independent from said frequency fx and from said second sampling frequency fs.

9. Device according to any of claims 5-8, wherein said device is a part of a Phase Locked Loop (100).

10. Network element comprising a device according to any of claims 5-9.

**Patentansprüche**

1. Verfahren zur digitalen Phasenmessung ($\Gamma x(t)$) eines Datensignals (x(t)) mit Frequenz fx-Wanderung in einem Übertragungsnetzwerk, wobei das besagte Verfahren umfasst:

- Bereitstellen eines Zählers (c(t));
- Erhöhen eines Wertes des besagten Zählers (c(t)) nach jedem Eintreten eines Ereignisses, um die Entwicklung des Datensignals (x(t)) mit der Frequenz fx zu markieren;
- Abtasten des Zählers (c(t)) bei einer ersten Abtastfrequenz fc, welche nicht mit der besagten Frequenz fx korreliert ist, wodurch eine erste Abtastwertfolge ($\{c_n\}$) erhalten wird,
- Abtasten der besagten ersten Abtastwertfolge ($\{c_n\}$) bei einer zweiten Abtastfrequenz fs, wodurch eine zweite Abtastwertfolge ($\{s_n\}$) erhalten wird; und
- Digitales Verarbeiten der besagten zweiten Abtastwertfolge ($\{s_n\}$), um die besagte Phase ($\Gamma x(t)$) des besagten Datensignals (x(t)) zu schätzen,

wobei das besagte Verfahren **dadurch gekennzeichnet ist, dass** der Schritt des Abtastens des besagten Zählers (c(t)) bei der besagten ersten Abtastfrequenz fc, welche nicht mit der besagten Frequenz fx korreliert ist, durch Abtasten des besagten Zählers (c(t)) bei der besagten Frequenz fc erfolgt, wobei fc=$\alpha\cdot$fx ist, wobei $\alpha$ eine irrationale Zahl ist.

2. Verfahren nach Anspruch 1, wobei der Schritt des digitalen Verarbeitens der besagten zweiten Abtastwertfolge ($\{s_n\}$) das digitale Filtern der besagten zweiten Abtastwertfolge ($\{s_n\}$) umfasst.

3. Verfahren nach einem beliebigen der Ansprüche, wobei die besagte Frequenz fx des besagten Datensignals (x(t)) und die besagte zweite Abtastfrequenz fs Frequenzen eines synchronen Übertragungssystems sind.

4. Verfahren nach einem beliebigen der vorstehenden Ansprüche, wobei die besagte erste Abtastfrequenz fc von einem von der besagten Frequenz fx und von der besagten zweiten Abtastfrequenz fs unabhängigen lokalen Oszillator erzeugt wird.

5. Vorrichtung zur digitalen Phasenmessung (rx(t)) eines Datensignals (x(t)) mit Frequenz fx-Wanderung in einem Übertragungsnetzwerk, wobei die besagte Vorrichtung umfasst:

- Einen Zählerblock (CNT), wobei der besagte Zählerblock (CNT) bei jedem Eintreten eines Ereignisses, welches die Entwicklung des Datensignals (x(t)) mit Frequenz fx markiert, einen Wert eines Zählers (c(t)) erhöht;
- ein Register (RG), wobei das besagte Register (RG) den Zähler (c(t)) bei einer ersten Abtastfrequenz fc, welche nicht mit der besagten Frequenz fx korreliert ist, abtastet, wodurch eine erste Abtastwertfolge ($\{c_n\}$) erhalten wird;
- eine Abtastvorrichtung (SMP), wobei die besagte Abtastvorrichtung (SMP) die besagte erste Abtastwertfolge ($\{c_n\}$) bei einer zweiten Abtastfrequenz fs abtastet, wodurch eine zweite Abtastwertfolge ($\{s_n\}$) erhalten wird; und
- einen Prozessor (DPA), wobei der besagte Prozessor (DPA) die besagte zweite Abtastwertfolge ($\{s_n\}$) digital verarbeitet, um die besagte Phase ($\Gamma$x(t)) des besagten Datensignals (x(t)) zu schätzen,

wobei die besagte Vorrichtung **dadurch gekennzeichnet ist, dass** das besagte Register (RG) ein Register ist, welches den Zähler (c(t)) bei einer ersten Abtastfrequenz fc abtastet, wobei fc=$\alpha\cdot$fx ist, wobei $\alpha$ eine irrationale Zahl ist.

6. Vorrichtung nach Anspruch 5, wobei der besagte Prozessor (DPA) die besagte zweite Abtastwertfolge ($\{s_n\}$) durch digitales Filtern der besagten zweiten Abtastwertfolge ($\{s_n\}$) digital verarbeitet.

7. Vorrichtung nach einem beliebigen der Ansprüche 5-6, wobei die besagte Frequenz fx des Datensignals (x(t)) und die besagte zweite Abtastfrequenz fs Frequenzen eines synchronen Übertragungssystems sind.

8. Vorrichtung nach einem beliebigen der Ansprüche 5-7, wobei die besagte erste Abtastfrequenz fc von einem von der besagten Frequenz fx und von der besagten zweiten Abtastfrequenz fs unabhängigen lokalen Oszillator erzeugt wird.

9. Vorrichtung nach einem beliebigen der Ansprüche 5-8, wobei die besagte Vorrichtung Bestandteil einer Phasenregelschleife (100) ist.

10. Netzwerkelement mit einer Vorrichtung gemäß einem beliebigen der Ansprüche 5-9 ist.

## Revendications

1. Procédé de mesure numérique de la phase ($\Gamma$x(t)) d'un signal de données (x(t)) ayant une fréquence fx se déplaçant dans un réseau de transmission, ledit procédé comprenant les étapes suivantes :

    - fourniture d'un compteur (c(t)) ;
    - augmentation d'une valeur dudit compteur (c(t)) suite à chaque occurrence d'un événement marquant l'évolution du signal de données (x(t)) ayant la fréquence fx ;
    - échantillonnage du compteur (c(t)) à une première fréquence d'échantillonnage fc non corrélée à ladite fréquence fx, pour obtenir une première séquence d'échantillon ($\{c_n\}$),
    - échantillonnage de ladite première séquence d'échantillon ($\{cn\}$ à une seconde fréquence d'échantillonnage fs, pour obtenir une seconde séquence d'échantillon ($\{s_n\}$) ; et
    - traitement numérique de ladite seconde séquence d'échantillon ($\{sn\}$) afin d'estimer ladite phase ($\Gamma$x(t)) dudit signal de données (x(t)),

ledit procédé étant **caractérisé en ce que** ladite étape d'échantillonnage dudit compteur (c(t)) à ladite première fréquence d'échantillonnage fc non corrélée à ladite fréquence fx est réalisée en échantillonnant ledit compteur (c(t)) à ladite fréquence fc avec fc=$\alpha$, où $\alpha$ est un nombre irrationnel.

2. Procédé selon la revendication 1, dans lequel l'étape de traitement numérique de ladite seconde séquence d'échantillon ($\{s_n\}$) comprend le filtrage numérique de ladite seconde séquence d'échantillon ($\{s_n\}$).

3. Procédé selon l'une quelconque des revendications précédentes, dans lequel ladite fréquence fx dudit signal de données (x(t)) et ladite seconde fréquence d'échantillonnage fs sont des fréquences d'un système de transmission synchrone.

4. Procédé selon l'une quelconque des revendications précédentes, dans lequel ladite première fréquence d'échantillonnage fc est générée par un oscillateur local indépendant de ladite fréquence fx et de ladite seconde fréquence d'échantillonnage fs.

**5.** Dispositif de mesure numérique de la phase (rx(t)) d'un signal de données (x(t)) ayant une fréquence fx se déplaçant dans un réseau de transmission, ledit dispositif comprenant :

- un bloc compteur (CNT), ledit bloc compteur (CNT) augmentant une valeur d'un compteur (c(t)) suite à chaque occurrence d'un événement marquant l'évolution du signal de données (x(t)) ayant la fréquence fx ; et
- un registre (RG), ledit registre (RG) échantillonnant le compteur (c(t)) à une première fréquence d'échantillonnage fc non corrélée à ladite fréquence fx, pour obtenir une première séquence d'échantillon ($\{c_n\}$),
- un échantillonneur (SMP), ledit échantillonneur (SMP) échantillonnant ladite première séquence d'échantillon ($\{cn\}$) à une seconde fréquence d'échantillonnage fs, pour obtenir une seconde séquence d'échantillon ($\{s_n\}$) : et
- un processeur (DPA), ledit processeur (DPA) effectuant un traitement numérique de ladite seconde séquence d'échantillon ($\{sn\}$) afin d'estimer ladite phase ($\Gamma x(t)$) dudit signal de données (x(t)),

ledit dispositif étant **caractérisé en ce que** ledit registre (RG) est un registre échantillonnant le compteur (c(t)) à une première fréquence d'échantillonnage fc avec fc=$\alpha$ fx, où $\alpha$ est un nombre irrationnel.

**6.** Dispositif selon la revendication 5, dans lequel ledit processeur (DPA) effectue un traitement numérique sur ladite seconde séquence d'échantillon ($\{s_n\}$) en filtrant numériquement ladite seconde séquence d'échantillon ($\{s_n\}$).

**7.** Dispositif selon l'une quelconque des revendications 5-6, dans lequel ladite fréquence fx dudit signal de données (x(t)) et ladite seconde fréquence d'échantillonnage fs sont des fréquences d'un système de transmission synchrone.

**8.** Dispositif selon l'une quelconque des revendications 5- 7, dans lequel ladite première fréquence d'échantillonnage fc est générée par un oscillateur local indépendant de ladite fréquence fx et de ladite seconde fréquence d'échantillonnage fs.

**9.** Dispositif selon l'une quelconque des revendications 5 à 8, dans lequel ledit dispositif fait partie d'une boucle à verrouillage de phase (100).

**10.** Élément de réseau comprenant un dispositif selon l'une quelconque des revendications 5 à 9.

x(t)

P0

$t_0$  $t_1$  $t_2$  $t_3$  $t_4$  $t_5$    $t_{n-3}$  $t_{n-2}$  $t_{n-1}$  $t_n$  $t_{n+1}$  $t_{n+2}$    t

## Fig. 1

**Fig. 2**

**Fig. 3**

**Fig. 4a**

Fig. 4b

**Fig. 5**

Fig. 6a

**Fig. 6b**

**Fig. 7**

**Fig. 8**

**Fig. 9**

**Fig. 10**

EP 1 640 733 B1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- EP 0446190 A

- US 6246738 B